(19) Europäisches Patentamt

European Patent Office

Office européen des brevets

(11) Veröffentlichungsnummer: **0 030 405**
**B1**

(12) # EUROPÄISCHE PATENTSCHRIFT

(45) Veröffentlichungstag der Patentschrift: **28.12.83**

(51) Int. Cl.³: **G 01 N 21/74,**
**C 23 C 11/10, C 04 B 35/54**

(21) Anmeldenummer: **80201162.7**

(22) Anmeldetag: **05.12.80**

(54) **Verfahren zur Herstellung von Küvetten für die flammenlose Atom-Absorptions-Spektroskopie.**

(30) Priorität: **08.12.79 DE 2949476**

(43) Veröffentlichungstag der Anmeldung:
**17.06.81 Patentblatt 81/24**

(45) Bekanntmachung des Hinweises auf die Patenterteilung:
**28.12.83 Patentblatt 83/52**

(84) Benannte Vertragsstaaten:
**DE FR GB**

(56) Entgegenhaltungen:
**DE - A - 2 034 960**
**DE - A - 2 420 546**
**DE - A - 2 450 261**
**DE - A - 2 702 189**
**DE - A - 2 825 759**
**GB - A - 1 168 505**

**PHILIPS TECHNICAL REVIEW, Band 37, Nr. 8, 1977, Eindhoven, NL, W.F. KNIPPENBERG et al.: "Products of pyrolytic graphite", Seiten 189-196**
**CHEMIE INGENIEUR TECHNIK, Band 41, Nr. 13, 1969, Weinheim, DE, B. LERSMACHER et al.: "Pyrolytischer Graphit und glasartige Kohle", Seiten 780-781**

(73) Patentinhaber: **Philips Patentverwaltung GmbH**
**Billstrasse 80**
**D-2000 Hamburg 28 (DE)**
(84) **DE**
(73) Patentinhaber: **N.V. Philips' Gloeilampenfabrieken**
**Groenewoudseweg 1**
**NL-5621 BA Eindhoven (NL)**
(84) **FR GB**

(72) Erfinder: **Lersmacher, Bernhard, Dr. Dipl.-Phys.**
**Schlossweiherstrasse 31**
**D-5100 Aachen (DE)**
Erfinder: **Bastings, Leonardus C. (verstorben)**
Erfinder: **van Kollenburg, Ludovicus W.J.**
**de Plank 14**
**Eindhoven (NL)**

(74) Vertreter: **Piegler, Harald, Dipl.-Chem. et al,**
**Philips Patentverwaltung GmbH Billstrasse 80**
**Postfach 10 51 49**
**D-2000 Hamburg 28 (DE)**

### Verfahren zur Herstellung von Küvetten für die flammenlose Atom-Absorptions-Spektroskopie

Die Erfindung betrifft ein Verfahren zur Herstellung von Küvetten für die flammenlose Atom-Absorptions-Spektroskopie (AAS), bei dem Grundkörper aus Kohlenstoff in einem Reaktionsgefäß durch reaktive Abscheidung aus der Gasphase (CVD-Verfahren) mit pyrolytischem Graphit beschichtet werden.

AAS-Küvetten dienen als Aufnahmebehälter und Aufheizvorrichtung für die zu analysierende Probe. Als Küvetten werden insbesondere rohrförmige Körper verwendet (DE—A1— 2 006 032, DE—B2—2 148 777). Im allgemeinen bestehen die Küvetten aus hochtemperaturfestem, elektrisch leitendem Material, da die Aufheizung der zu analysierenden Probe meistens durch Widerstandsbeheizung der Küvetten im direkten Stromdurchgang erfolgt. Natürlich sind auch andere Beheizungsarten, z.B. induktiv oder durch Strahlung, möglich.

Das bevorzugte Material für solche Küvetten ist Kohlenstoff, insbesondere in Form spektralreiner Elektrographite. Ferner ist es bekannt, Küvetten aus glasartigem Kohlenstoff herzustellen (DE—A1—2 034 960).

Die Porosität der zuvor erwähnten Graphite hat zur Folge, daß Analysensubstanz in die Küvettenwandung eindringt und sich dadurch bei wiederholtem Gebrauch der Küvette Restsubstanz einer Analyse auf die Ergebnisse nachfolgender Analysen verfälschend auswirkt. Man nennt diese Erscheinung "memory effect". Ferner beeinträchtigt dieses Eindringen von Analysensubstanz in die Küvettenwände auch die Nachweisgrenze und die Empfindlichkeit der Analyse. Insbesondere wird auch die Gebrauchs- oder Lebensdauer der Küvetten durch das Eindringen von Analysensubstanz in die Graphitwände sehr stark reduziert, da sie während der Analyse, bei der Temperaturen bis zu 3000°C vorkommen können, sehr stark korrodierend wirkt.

Um die genannten Nachteile zu verhindern oder ganz zu vermeiden, empfiehlt es sich, den Zugang zu den Porenkanälen (und den besonders korrosionsanfälligen Korngrenzen) des Graphits zu versiegeln. Dies geschieht, wie z.B. aus der DE—A1—2 702 189 bekannt, durch Aufbringen einer dünnen Schicht aus pyrolytischem Graphit auf den porösen Grundkörper, wobei der pyrolytische Graphit schon in Schichtdicken von wenigen Mikrometern (5 bis 10 $\mu$m) eine wirkungsvolle Diffusionsbarriere darstellt. Dies äußert sich u.a. darin, daß beispielsweise — nach eigenen Messungen — sowohl die Empfindlichkeit als auch besonders die Lebensdauer deutlich erhöht werden.

Zusammenfassend kann der Stand der Technik so dargestellt werden, daß unbeschichtete Graphitküvetten 10 bis 100 Analysen aushalten (eine Angabe von "200" enthält die DE—A1—2 034 960); bei mit pyrolytischem Graphit beschichteten Küvetten erhöht sich die Wiederverwendbarkeit bei gleichzeitiger Verbesserung der Empfindlichkeit, jedoch sind die Angaben in der Literatur über den Faktor der Lebensdauererhöhung teilweise widersprüchlich und unverbindlich. — In diesem Zusammenhang sei auf die Veröffentlichung von Manning und Edinger in Atomic Absorption Newsletter, Vol. 15, Nr. 2, March—April 1976, S. 42 bis 44, verwiesen. Hier handelt es sich um eine sogenannte "in situ"-Beschichtung. Aus den Angaben ist zu entnehmen, daß zwar eine erhöhte Empfindlichkeit erreicht wird, jedoch mit etwa 100facher Wiederverwendbarkeit kein besonderer Vorzug gegenüber der unbeschichteten Küvette zu erreichen ist. Außerdem ist das "in situ"-Beschichtungsverfahren sehr umständlich, schlecht kontrollierbar hinsichtlich der Qualität der Beschichtung und muß offenbar in relativ kurzen Zeitabständen, z.B. spätestens nach 8 Analysen, wiederholt werden.

Aus der DE—A1—2 450 261 ist es bekannt, bei der Herstellung von Gitterelektroden für Elektronenröhren, bei der pyrolytischer Graphit durch thermische Zersetzung von kohlenstoffhaltigen Gasen auf einem Dorn niedergeschlagen und der so gebildete Formkörper vom Dorn getrennt und mit gitterförmigen Öffnungen versehen wird, den Formkörper nach dem Ausbilden des Gitters nochmals mit einer dünnen Schicht aus pyrolytischem Graphit zu überziehen. Durch diese Zweitbeschichtung wird bewirkt, daß die beim Herstellen der gitterförmigen Öffnungen geschaffenen, vakuumtechnisch und mechanisch ungünstigen Oberflächen des pyrolytischen Graphits abgedeckt werden.

Der Erfindung liegt demgegenüber die Aufgabe zugrunde, eine Küvette mit hoher Empfindlichkeit zu schaffen, deren primäre Verbesserung jedoch in einer merklich erhöhten Lebensdauer zu erkennen ist. — Die technische Bedeutung langer Lebendauern wird besonders deutlich, wenn man die Aufgabe automatisierter AAS-Geräte bedenkt, wie sie beispielsweise zur routinemäßigen Überwachung etwa der Verunreinigung von Gewässern oder der Luft verwendet werden.

Diese Aufgabe wird erfindungsgemäß durch ein Verfahren der eingangs genannten Art gelöst, bei dem die beschichteten Grundkörper nach Abkühlen von Abscheidungstemperatur auf Zimmertemperatur aus dem Reaktionsgefäß herausgenommen werden, dann wieder in das Reaktionsgefäß derart eingebracht werden, daß die einzelnen beschichteten Grundkörper eine andere Lage als bei der vorhergegangenen Beschichtung einnehmen, und dann noch mindestens ein weiteres Mal mit pyrolytischem Graphit beschichtet werden und bei dem Schichten aus pyrolytischem Graphit mit einer Gesamtdicke von 20 bis 80 $\mu$m erzeugt werden.

Vorzugsweise werden Schichten mit einer Gesamtdicke von 20 bis 40 $\mu$m erzeugt.

Es empfiehlt sich nicht, Schichten, die dicker als 80 $\mu$m sind, herzustellen, weil bei derart dicken Schichten die Gefahr des Abblätterns besteht. Außerdem verändert sich der elektrische Widerstand einer Küvette mit zunehmender Schichtdicke sehr start, was sich vielfach für die Funktion des verwendeten Analysegerätes als nachteilig herausstellt.

Das Herausnehmen der Grundkörper nach dem Abkühlen und das Wiedereinbringen (Umfüllen) in der Weise, daß die Grundkörper an andere Orte und in eine andere Lage bzw. Position gelangen, erfolgt bei mehr als zwei Beschichtungen jeweils vor jeder weiteren Beschichtung erneut in der geschilderten Weise.

Das Einbringen und das Wiedereinbringen kann auch durch Einfüllen in einen im Reaktionsgefäß befindlichen korbartigen Graphitbehälter erfolgen.

Die Abscheidungstemperatur liegt bei der reaktiven Abscheidung von pyrolytischem Graphit bei etwa 2000°C.

Es empfiehlt sich, mindestens eine der aufeinanderfolgenden Beschichtungen mittels Heißwandpyrolyse vorzunehmen. Die Heißwandpyrolyse ist aus Philips Techn. Tijdschrift 37 (1977) Nr. 7, S. 161 bis 168, bekannt. Die Anwendung dieses Verfahrens hat den Vorteil, daß eine Vielzahl (des Massenartikels) Küvetten gleichzeitig beschichtet werden können, was aus ökonomischen Gründen wichtig ist. Das Verfahren ist unabhängig von der Form und Lage der einzelnen Küvetten, da die Beheizung auf gleichförmige Temperaturen und damit Gleichförmigkeit der abgeschiedenen Schichten im Innern der Küvetten gewährleistet ist. Die einzelnen Küvetten brauchen nicht ausgerichtet Stück für Stück im Reaktionsgefäß untergebracht zu werden, sondern werden einfach hineingeschüttet. Darin ist ein gewisser Nachteil des Verfahrens zu sehen, da es zwischen den in den Beschichtungsraum eingebrachten Küvetten zwangsläufig Kontaktstellen gibt, die eine Ungleichmäßigkeit der Dicke der Außenbeschichtung zur Folge haben. Dieser Nachteil des Verfahrens wird dadurch weitestgehend kompensiert, daß das Haufwerk umgeschichtet wird, d.h. daß bei nachfolgenden Beschichtungen durch diese Umverteilung im allgemeinen jede Einzelküvette sowohl eine andere Position im Reaktor als auch andere Berührungsstellen mit den Nachbarn hat. Diese Umschichtung oder Umverteilung nach jeder Vorbeschichtung kann mehrere Male erfolgen, jedoch hat es sich gezeigt, daß eine einmalige Umschichtung, d.h. also, das Aufbringen der Schichten in zwei Schritten, veilfach ausreichend ist.

Die zu beschichtenden Grundkörper bestehen im allgemeinen aus Graphit, insbesondere aus Elektrographit. In manchen Fällen ist es zweckmäßig, Grundkörper aus glasartigem Kohlenstoff zu beschichten. Besonders vorteilhaft ist es, mit dem erfindungsgemäßen Verfahren Grundkörper aus karbonisiertem Hartgewebe auf Basis härtbarer, in glasartigen Kohlenstoff umwandelbarer Kunstharze, z.B. Phenolharz oder Kresolharz, und Baumwollgewebe zu beschichten. Derartige Küvetten-Grundkörper sind aus der DE—A1—2 702 189 bekannt.

Nach einer weiteren Ausgestaltung des erfindungsgemäßen Verfahrens werden die Oberflächen des Grundkörpers, insbesondere die Oberfläche des Innenraumes der Küvetten, die zu Beginn der Analyse in unmittelbaren Kontakt mit der zu analysierenden Probe kommt, vor der Beschichtung möglichst gut geglättet, z.B. poliert.

Nach dem erfindungsgemäßen Verfahren werden Küvetten hergestellt, die sich durch eine hohe Gleichförmigkeit und gute Struktur der protektiven Schichten aus pyrolytischem Graphit sowohl im Innern, aber auch auf der Außenseite auszeichnen. Überraschend war es dabei, im Verlaufe zahlreicher Messungen zu erfahren, daß die nach dem erfindungsgemäßen Verfahren hergestellten Küvetten eine extrem lange Lebensdauer (extrem hohe Anzahl von Injektionen, Analysen) zeigten, wenn die Schichten aus pyrolytischem Graphit ein Dicke von mehr als 20 $\mu$m, insbesondere eine Dicke von etwa 30 bis 40 $\mu$m, aufwiesen.

Die Erfindung wird anhand einiger Ausführungsbeispiele näher erläutert.

### Beispiel 1

Es wurden 600 Stück rohrförmige Küvetten von 28 mm Länge, 8 mm Außendurchmesser, 6 mm Innendurchmesser aus Graphit gleichzeitig in ein Heißwand Reaktionsgefäß eingebracht und in 6 Beschichtungsgängen von je 1 Stunde Dauer, also mit 5 Umverteilungen, die nach Abkühlen auf Zimmertemperatur durch Herausnahme aus dem Reaktionsgefäß und Wiedereinfüllen unter Beachtung einer geänderten Positionierung der einzelnen Grundkörper vorgenommen wurden, unter Wiederholung aller Einzelmaßnahmen, die für die Beschichtung mit pyrolytischem Graphit erforderlich sind, also Evakuieren des Reaktionsgefäßes mittels Pumpen auf einen Enddruck von 1,33 · 10$^{-6}$ bar oder niedriger, Aufheizen des Reaktionsgefäßes auf etwa 2000°C und Einlassen des zu pyrolysierenden Gases (in diesem Falle Propan) in richtig dosierter Menge (in diesem Falle 2 Mol/h), mit einer Schicht aus gut orientiertem pyrolytischem Graphit versehen.

Die gesamte Schichtdicke betrug zum Schluß etwa 37 $\mu$m.

In einem Test unter Realbedingungen, bei dem jeweils eine Analysenlösung von Aluminium in 0,1 n Salpetersäure injiziert wurde und dann der vorgeschreibene Temperatur-Zeit-Zyklus (bis T = 3000 K) durchfahren wurde, zeigte es sich, daß eine Küvette 610 bis 1200 derartige Zyklen aushielt.

Beispiel 2

Auf gleiche Art und Weise hergestellte Küvetten hielten unter gleichen Temperatur-Zeit-Abläufen 320 bis 700 Injektionen aus, wenn anstelle von 0,1 n HNO$_3$ eine Lösung von Aluminium in 0,1 n Perchlorsäure injiziert wurde.

Beispiel 3

Es wurden 250 Graphitküvetten unter sonst gleichen Bedingungen mit gut orientiertem pyrolytischem Graphit beschichtet. Die Beschichtung auf Schichtdicken von etwa 40 µm erfolgte jedoch in 2 Schritten, also mit nur einer Umlagerung. Unter den in Beispiel 1 und 2 angegebenen Analysenbedingungen wurden Lebensdauern von >3000 Injektionen erreicht. Die Tests wurden bei diesem Stand abgebrochen, obwohl die Küvetten noch funktionstüchtig waren.

**Patentansprüche**

1. Verfahren zur Herstellung von Küvetten für die flammenlose Atom-Absorptions-Spektroskopie, bei dem Grundkörper aus Kohlenstoff in einem Reaktionsgefäß durch reaktive Abschiedung aus der Gasphase mit pyrolytischem Graphit beschichtet werden, dadurch gekennzeichnet, daß die beschichteten Grundkörper nach Abkühlen von Abscheidungstemperatur auf Zimmertemperatur aus dem Reaktionsgefäß herausgenommen werden, dann wieder in das Reaktionsgefäß derart eingebracht werden, daß die einzelnen beschichteten Grundkörper eine andere Lage als bei der vorhergegangenen Beschichtung einnehmen, und dann noch mindestens ein weiteres Mal mit pyrolytischem Graphit beschichtet werden, und daß Schichten aus pyrolytischem Graphit mit einer Gesamtdicke von 20 bis 80 µm erzeugt werden.

2. Verfahren nach Anspruch 1, dadurch gekennzeichnet, daß Schichten mit einer Gesamtdicke von 30 bis 40 µm erzeugt werden.

3. Verfahren nach Anspruch 1 oder 2, dadurch gekennzeichnet, daß eine der aufeinanderfolgenden Beschichtungen mittels Heißwandpyrolyse vorgenommen wird.

4. Verfahren nach Anspruch 1, 2 oder 3, dadurch gekennzeichnet, daß die zu beschichtenden Grundkörper in Form einer losen Schüttung in eine Pyrolysiervorrichtung eingebracht und vor Durchführung der weiteren Beschichtungen bei Zimmertemperatur umgeschichtet bzw. umgelagert werden.

5. Verfahren nach Anspruch 1 bis 4, dadurch gekennzeichnet, daß Grundkörper aus Graphit beschichtet werden.

6. Verfahren nach Anspruch 1 bis 4, dadurch gekennzeichnet, daß Grundkörper aus glasartigem Kohlenstoff beschichtet werden.

7. Verfahren nach Anspruch 1 bis 4, dadurch gekennzeichnet, daß Grundkörper beschichtet werden, die aus karbonisiertem Hartgewebe auf Basis härtbarer, in glasartigen Kohlenstoff umwandelbarer Kunstharze und Baumwollgewebe bestehen.

8. Verfahren nach Anspruch 1 bis 7, dadurch gekennzeichnet, daß die Oberflächen des Grundkörpers, insbesondere die Oberfläche des Innenraumes der Küvetten, die zu Beginn der Analyse in unmittelbaren Kontakt mit der zu analysierenden Probe kommt, vor der Beschichtung möglichst gut geglättet werden.

**Revendications**

1. Procédé pour la fabrication de cuvettes pour la spectroscopie par absorption atomique sans flammes, selon lequel des corps de base en carbone sont recouverts de graphite pyrolytique dans un récipient à réaction par séparation réactive à partir de la phase gazeuse, caractérisé en ce que les corps de base recouverts sone sortis du récipient à réaction après refroidissement de la température de précipitation jusqu'à la temperature ambiante normale, puis réintroduits dans le récipient à réaction, que les corps de base recouverts occupent une autre position que cors due recouvrement précédent, et qu'ensuite suit encore au moins un autre recouvrement de graphite pyrolytique, opération lors de laquelle s'obtiennent des couches en graphite pyrolytique présentant une épaisseur totale de 20 à 80 µm.

2. Procédé selon la revendication 1, caractérisé en ce que des couches sont obtenues dans une épaisseur totale de 30 à 40 µm.

3. Procédé selon la revendication 1 ou 2, caracterisé en ce que l'une des recouvrements successifs est appliqué par pyrolyse à paroi chaude.

4. Procédé selon la revendication 1, 2 ou 3, caractérisé en ce que les corps de base à recouvrir sont introduits en vrac dans un dispositif de pyrolyse et sont repositionnés pour la réalisation des autres recouvrements à la température ambiante normale.

5. Procédé selon les revendications 1 à 4, caractérisé en ce que les corps de base en graphite sont recouverts.

6. Procédé selon les revendications 1 à 4, caractérisé en ce que des corps de base en carbone vitreux sont recouverts.

7. Procédé selon la revendication 1 à 4, caractérisé en ce que des corps de base sont recouverts, qui sont constitués par du tissu bakélisé carbonisé à base de résine synthétique durcissante, pouvant être transformés en carbone vitreux et du tissu de coton.

8. Procédé selon les revendications 1 à 7, caractérisé en ce que les surfaces des corps de base, notamment les surfaces de l'enceinte intérieure des cuvettes entrant en contact immédiat avec l'échantillon à analyser au début de l'analyse sont lissées le mieux possible avant le recouvrement.

## Claims

1. A method of making crucibles for flameless atomic absorption spectroscopy wherein preforms of carbon are coated with pyrolytic graphite in a reaction vessel by reactive deposition from the gaseous phase, characterized in that the coated preforms are removed from the reaction vessel after cooling from deposition temperature to room temperature and are then reintroduced into the reaction vessel so that the individual coated preforms assume different positions in comparison with their positions in the previous coating process and are then coated again at least once with pyrolytic graphite, producing pyrolytic graphite coatings to a total thickness of 20 to 80 $\mu$m.

2. A method as claimed in Claim 1, characterized in that coatings with a total thickness of 30 to 40 $\mu$m are produced.

3. A method as claimed in Claim 1 or 2, characterized in that one of the successive coatings is produced by hot-wall pyrolysis.

4. A method as claimed in Claim 1, 2 or 3, characterized in that the preforms to be coated are introduced into a pyrolysis apparatus in a random arrangement and are reshifted or rearranged at room temperature before the further coating processes are performed.

5. A method as claimed in Claims 1 to 4, characterized in that graphite preforms are coated.

6. A method as claimed in Claims 1 to 4, characterized in that vitreous carbon preforms are coated.

7. A method as claimed in Claims 1 to 4, characterized in that preforms are coated which consist of carbonised rigid fabric, based on curable synthetic resins convertible into vitreous carbon, and cotton fabric.

8. A method as claimed in Claims 1 to 7, characterized in that the surfaces of the preform, especially the inner surface of the crucibles which receives the sample to be analysed at the start of analysis is as highly polished as possible before coating.